# EUROPEAN PATENT APPLICATION

(11) **EP 4 730 962 A1**
(43) Date of publication of application: **22.04.2026**
(21) Application number: 24905351.3
(22) Date of filing: 01.04.2024
(51) Int. Cl.: H10F 77/14, H10F 77/30, H10F 77/20

(54) **TOPCON SOLAR CELL, BATTERY ASSEMBLY AND PHOTOVOLTAIC SYSTEM**

(30) Priority: 22.12.2023 CN 202323527045 U
(71) Applicant: Zhejiang Aiko Solar Energy Technology Co., Ltd., Yiwu, Jinhua Zhejiang 322000 (CN); Tianjin Aiko Solar Energy Technology Co., Ltd., Tianjin 300400 (CN); Zhuhai Fushan Aiko Solar Energy Technology Co., Ltd., FushanIndustrial Park, Doumen District Zhuhai Guangdong 519000 (CN); Guangdong Aiko Solar Energy Technology Co., Ltd., Foshan, Guangdong 528000 (CN); Shenzhen Aiko Digital Energy Technology Co., Ltd., Shenzhen, Guangdong 518000 (CN)
(72) Inventor: WANG, Yongqian, Jinhua, Zhejiang 322000 (CN); ZHANG, jianjun, Jinhua, Zhejiang 322000 (CN); YANG, Xinqiang, Jinhua, Zhejiang 322000 (CN); CHEN, Gang, Jinhua, Zhejiang 322000 (CN)
(74) Representative: EP&C
(86) International application number: PCT/CN2024/085307
(87) International publication number: WO 2025/129847

(57) **Abstract**

The present disclosure is applicable to the technical field of solar cells, and provides a Topcon solar cell (100), a cell assembly (200), and a photovoltaic system (1000). A silicon substrate (10) of the Topcon solar cell (100) has a first surface (11) and a second surface (12) opposite to each other. A first tunneling oxide layer (20), a first polarity doped layer (30), and a first passivation layer (40) are sequentially stacked on the first surface (11), and a second polarity doped layer (50) and a second passivation layer (60) are sequentially stacked on the second surface 12. A first metal electrode (70) is arranged on the first passivation layer (40), and a second metal electrode (80) is arranged on the second passivation layer (60). In an extension direction of the first metal electrode (70), a plurality of first barrier isolation layers (90) arranged at intervals are located below the first metal electrode (70), and the first metal electrode (70) is made of a burn-through paste. At a position corresponding to the first barrier isolation layer (90), the first metal electrode (70) burns through the first passivation layer (40) to be in contact with the first barrier isolation layer (90), and between two adjacent first barrier isolation layers (90), the first metal electrode (70) burns through the first passivation layer (40) to be in contact with the first polarity doped layer (30), wherein the first barrier isolation layer (90) is obtained by partially removing a wrap plating layer formed on the first polarity doped layer (30) in the process of forming the second polarity doped layer (50).

## Description

### Priority Information

This application claims priority and benefits to Chinese Patent Application No. 202323527045.8, filed to the China National Intellectual Property Administration on December 22, 2023, the disclosure of which is hereby incorporated by reference in its entirety.

### Technical Field

The present disclosure relates to the technical field of solar cells, and in particular, to a Topcon solar cell, a cell assembly, and a photovoltaic system.

### Background

At present, in a Topcon solar cell, both front and back sides of a silicon wafer have doped layers, and polarities of the two doped layers are opposite. At the same time, both the front and back sides have passivation layers and secondary grids.

In the related art, the secondary grid is usually made of a burn-through paste. In the process of printing the paste to form an electrode, the paste of the secondary grid burns through the passivation layer to be in direct contact with the doped layer below. However, at a position of the secondary grid, the burn-through paste usually burns through the passivation layer to be in full contact with the doped layer below. That is, the secondary grid is in full contact with the doped layer, and cannot selectively burn through the passivation layer.

### Summary

The present disclosure provides a Topcon solar cell, a cell string, a cell assembly, and a photovoltaic system.

The present disclosure is implemented as follows: the Topcon solar cell in embodiments of the present disclosure includes: a silicon substrate, a first tunneling oxide layer, a first polarity doped layer, a first passivation layer, a second polarity doped layer, a second passivation layer, a first metal electrode, and a second metal electrode.

The silicon substrate has a first surface and a second surface opposite to each other.

The first tunneling oxide layer, the first polarity doped layer, and the first passivation layer are sequentially stacked on the first surface.

The second polarity doped layer and the second passivation layer are sequentially stacked on the second surface. A polarity of the second polarity doped layer is opposite to that of the first polarity doped layer.

The first metal electrode is arranged on the first passivation layer, and the second metal electrode is arranged on the second passivation layer.

In an extension direction of the first metal electrode, a plurality of first barrier isolation layers arranged at intervals are located below the first metal electrode, the first barrier isolation layer is located between the first passivation layer and the first polarity doped layer, and the first metal electrode is made of a burn-through paste.

At a position corresponding to the first barrier isolation layer, the first metal electrode burns through the first passivation layer to be in contact with the first barrier isolation layer, and between two adjacent first barrier isolation layers, the first metal electrode burns through the first passivation layer to be in contact with the first polarity doped layer, and the second metal electrode at least partially penetrates through the second passivation layer to be in contact with the second polarity doped layer.

The first barrier isolation layer is obtained by partially removing a wrap plating layer formed on the first polarity doped layer in the process of forming the second polarity doped layer.

Further, in the extension direction of the first metal electrode, a ratio of a length of the first metal electrode in contact with the first polarity doped layer to a total length of the first metal electrode is 30%-80%.

Further, in the extension direction of the first metal electrode, the ratio of the length of the first metal electrode in contact with the first polarity doped layer to the total length of the first metal electrode is 40%-60%.

Further, the first barrier isolation layer includes an insulating isolation layer stacked on the first polarity doped layer and a barrier doped layer stacked on the insulating isolation layer, and at the position corresponding to the first barrier isolation layer, the first metal electrode burns through the first passivation layer to be in contact with the barrier doped layer, and a polarity of the barrier doped layer is the same as that of the second polarity doped layer.

Further, the first polarity doped layer is a P-type doped layer, and the second polarity doped layer and the barrier doped layer are both N-type doped layers.

Further, a bonding tension between the first metal electrode and the barrier doped layer is greater than a bonding tension between the first metal electrode and the first polarity doped layer. And/or
A bonding tension between the barrier doped layer and the first passivation layer is greater than a bonding tension between first polarity doped layer and the first passivation layer.

Further, the Topcon solar cell further includes a solder joint connected to the first metal electrode. The solder joint is arranged on the first passivation layer and at least partially located above the barrier doped layer.

Further, a projected area of the barrier doped layer on the silicon substrate is greater than or equal to a projected area of the solder joint on the silicon substrate, and the solder joint is completely located in a projection region of the barrier doped layer.

Further, the first surface has at least one first region and at least one second region which are sequentially and alternately arranged, the first polarity doped layer is arranged on the first region and does not cover the second region, and at least one first barrier isolation layer is arranged above the first polarity doped layer on the at least one first region.

Further, an area ratio of the first region to the first surface is less than 8%.

Further, in an extension direction of the second metal electrode, at a position corresponding to the second metal electrode, a plurality of second barrier isolation layers arranged at intervals in the extension direction of the second metal electrode are arranged between the second polarity doped layer and the second passivation layer, and the second metal electrode is also made of the burn-through paste.

At a position corresponding to the second barrier isolation layer, the second metal electrode burns through the second passivation layer to be in contact with the second barrier isolation layer, and between two adjacent second barrier isolation layers, the second metal electrode burns through the second passivation layer to be in contact with the second polarity doped layer, and the second barrier isolation layer includes a phosphosilicate glass layer or a borosilicate glass layer.

Further, a second tunneling oxide layer is arranged between the second polarity doped layer and the second surface.

Further, the second surface has at least one third region and at least one fourth region which are sequentially and alternately arranged, and the second polarity doped layer is arranged on the third region and does not cover the fourth region.

Further, an area ratio of the third region to the second surface is greater than or equal to 30% and less than 100%.

The present disclosure further provides a cell assembly, including at least one the above Topcon solar cell.

The present disclosure further provides a photovoltaic system, including the above cell assembly.

Additional aspects and advantages of the present disclosure will be given in part in the following description, and in part will become apparent from the following description, or be learned through the practice of the present disclosure.

### Brief Description of the Drawings

Fig. 1 is a schematic structural diagram of a photovoltaic system provided by an embodiment of the present disclosure.
Fig. 2 is a schematic diagram of a planar structure of a Topcon solar cell provided by an embodiment of the present disclosure.
Fig. 3 is a schematic cross-sectional view of a Topcon solar cell along line III-III in Fig.2.
Fig. 4 is a schematic cross-sectional view of a Topcon solar cell along line IV-IV in Fig.2.
Fig. 5 is another schematic cross-sectional view of a Topcon solar cell along line III-III in Fig.2.
Fig. 6 is still another schematic cross-sectional view of a Topcon solar cell along line III-III in Fig.2.
Fig. 7 is still another schematic cross-sectional view of a Topcon solar cell along line III-III in Fig.2.
Fig. 8 is another schematic cross-sectional view of a Topcon solar cell along line IV-IV in Fig.2.

### Description of main component symbols:

Photovoltaic system 1000, cell assembly 200, Topcon solar cell 100, silicon substrate 10, first surface 11, second surface 12, first tunneling layer 20, first polarity doped layer 30, first passivation layer 40, second polarity doped layer 50, second passivation layer 60, first metal electrode 70, second metal electrode 80, first barrier isolation layer 90, insulating isolation layer 91, barrier doped layer 92, second barrier isolation layer 110, and second tunneling oxide layer 120.

### Detailed Description of the Embodiments

In order to make the purposes, technical solutions and advantages of the present disclosure clearer, the present disclosure will be further described below in detail in conjunction with the drawings and embodiments. Examples of the embodiments are shown in the drawings, where the same or similar reference signs throughout refer to the same or similar elements or elements having the same or similar functions. It is to be noted that the embodiments described below with reference to the drawings are exemplary and are only used to explain the present disclosure, and are not to be construed as limiting the present disclosure. In addition, it is to be understood that that the specific embodiments described herein are only used to illustrate the present disclosure, but are not intended to limit the present disclosure.

In the description of the present disclosure, it is to be understood that the orientations or positional relationships indicated by the terms "upper", "down", "left", "right", "transverse", "longitudinal", etc. are based on the orientations or positional relationships shown in the drawings, and are only for the convenience of describing the present disclosure and simplifying the description. The description does not indicate or imply that the device or element referred to must have a specific orientation, be constructed and operated in a specific orientation, and therefore cannot be construed as limiting the present disclosure.

In addition, the terms "first" and "second" are used for descriptive purposes only, and cannot be understood as indicating or implying relative importance. Therefore, the features defined with "first" and "second" may explicitly or implicitly include one or more features. In the description of the present disclosure, "a plurality" means two or more, unless otherwise specified and defined.

In the present disclosure, unless otherwise specified and defined, the first feature being "on" or "under" the second feature may include direct contact of the first and second features, or may include situations where the first and second features are not in direct contact but are in contact through additional features between them. Moreover, the first feature being "over", "above" and "on" the second feature includes the first feature being directly above and obliquely above the second feature, or simply indicates that the horizontal height of the first feature is greater than that of the second feature. The first feature being "underneath", "below" and "under" the second feature includes the first feature being directly below and obliquely below the second feature, or simply indicates that the horizontal height of the first feature is less than that of the second feature.

The following disclosure provides various different embodiments or examples for implementing different structures of the present disclosure. In order to simplify the disclosure of the present disclosure, components and settings of specific examples are described below. They are, of course, examples only and are not intended to limit the present disclosure. In addition, the present disclosure may repeat reference numerals and/or reference letters in different examples, and this repetition is for the purposes of simplification and clarity and does not in itself indicate the relationship between the various embodiments and/or settings discussed. In addition, examples of various specific processes and materials are provided in the present disclosure, but those of ordinary skill in the art may realize the application of other processes and/or the use scenarios of other materials.

### Embodiment 1

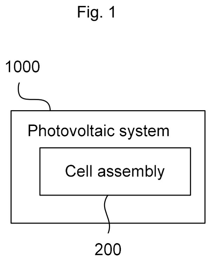

Referring to Fig. 1, a photovoltaic system 1000 in the embodiment of the present disclosure may include a cell assembly 200 in the embodiment of the present disclosure. The cell assembly 200 in the embodiment of the present disclosure may include at least one Topcon solar cell 100 in the embodiment of the present disclosure. At least one Topcon solar cell 100 in the cell assembly 200 may be sequentially connected in series through solder strips to form a cell string. The cell strings in the cell assembly 200 may be connected in series, in parallel, or in series-parallel combination to achieve convergence and output of current. For example, the connection between the cell strings may be achieved through a bus bar.

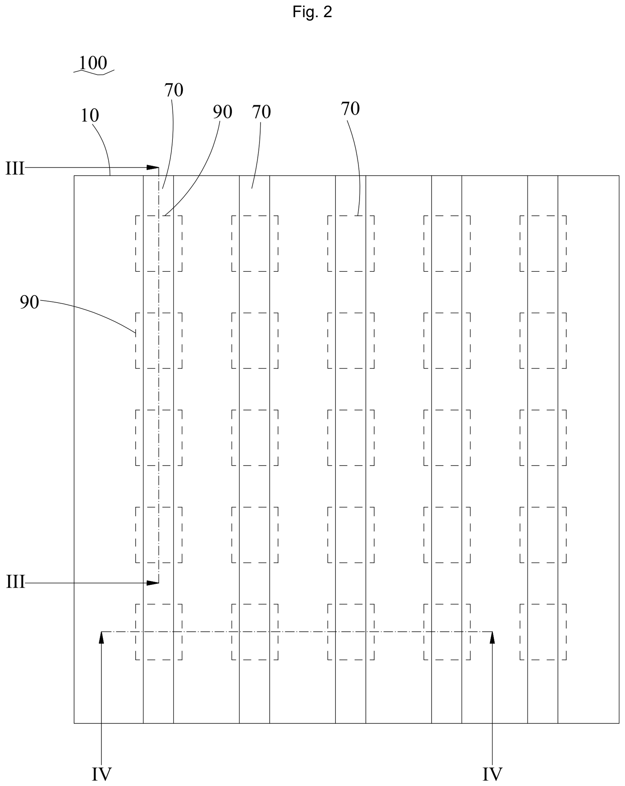

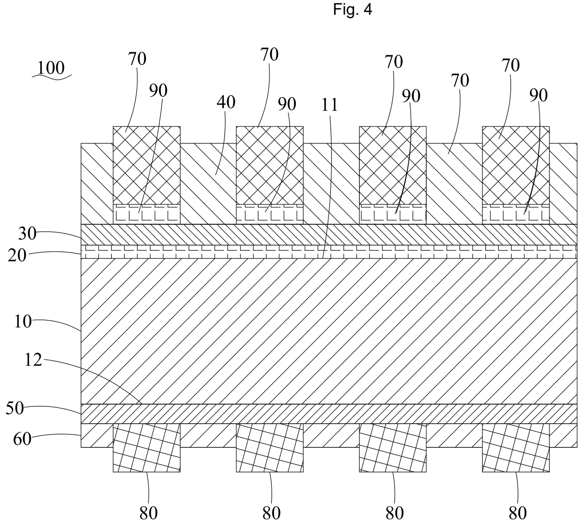

Referring to Fig. 2 to Fig. 4, the Topcon solar cell 100 in the embodiment of the present disclosure may include a silicon substrate 10, a first tunneling oxide layer 20, a first polarity doped layer 30, a first passivation layer 40, a second polarity doped layer 50, a second passivation layer 60, a first metal electrode 70, a second metal electrode 80, and a plurality of first barrier isolation layers 90.

The silicon substrate 10 has a first surface 11 and a second surface 12 opposite to each other, and the two are front and back sides of the silicon substrate 10 respectively, which are not specifically limited herein. The first tunneling oxide layer 20, the first polarity doped layer 30, and the first passivation layer 40 are sequentially stacked on the first surface 11, and the second polarity doped layer 50 and the second passivation layer 60 are sequentially stacked on the second surface 12.

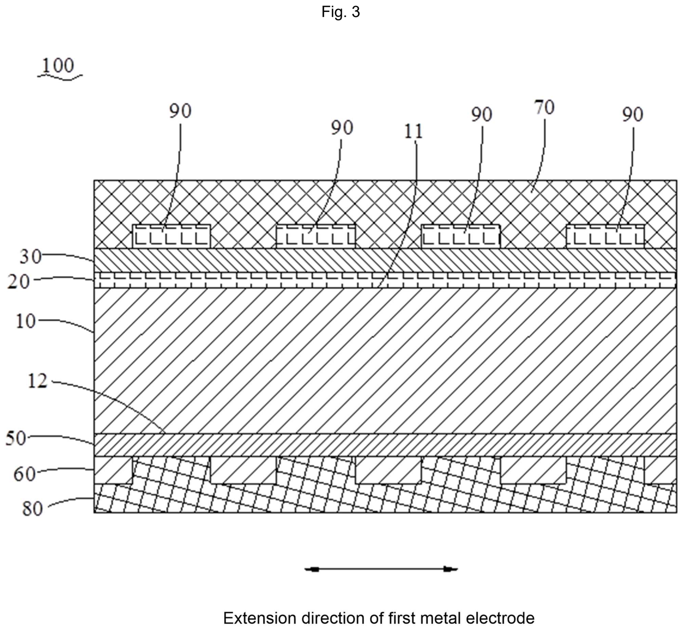

The first metal electrode 70 is arranged on the first passivation layer 40, and the second metal electrode 80 is arranged on the second passivation layer 60. As shown in Fig. 3, in an extension direction of the first metal electrode 70, a plurality of first barrier isolation layers 90 arranged at intervals are located below the first metal electrode 70, the first barrier isolation layers 90 are located between the first passivation layer 40 and the first polarity doped layer 30, and the first metal electrode 70 is made of a burn-through paste.

At a position corresponding to the first barrier isolation layer 90, the first metal electrode 70 burns through the first passivation layer 40 to be in contact with the first barrier isolation layer 90, and between two adjacent first barrier isolation layers 90, the first metal electrode 70 burns through the first passivation layer 40 to be in contact with the first polarity doped layer 30, and the second metal electrode 80 at least partially penetrates through the second passivation layer 60 to be in contact with the second polarity doped layer 50. The first barrier isolation layer 90 is obtained by partially removing a wrap plating layer formed on the first polarity doped layer 30 in the process of forming the second polarity doped layer 50. (It is to be noted that, since Fig. 3 is a cross-sectional view along the extension direction of the first metal electrode 70, at this position, the first passivation layer 40 is substantially completely ablated, and therefore, the first passivation layer 40 is not shown in Fig. 3).

In the Topcon solar cell 100, the cell assembly 200, and the photovoltaic system 1000 in the embodiments of the present disclosure, between the first polarity doped layer 30 and the first passivation layer 40, at least one first barrier isolation layer 90 is arranged at intervals in the extension direction of the first metal electrode 70, at the position corresponding to the first barrier isolation layer 90, the first metal electrode 70 burns through the first passivation layer 40 to be in contact with the first barrier isolation layer 90, and between two adjacent first barrier isolation layers 90, the first metal electrode 70 burns through the first passivation layer 40 to be in contact with the first polarity doped layer 30, and the second metal electrode 80 at least partially penetrates through the second passivation layer 60 to be in contact with the second polarity doped layer 50. In this way, in the process of manufacturing the first metal electrode 70 by using the burn-through paste, the first metal electrode 70 only burns through the first passivation layer 40 at the interval between the first barrier isolation layers 90 to be in contact with the first polarity doped layer 30, and only burns through the first passivation layer 40 at the position corresponding to the first barrier isolation layer 90 to be in contact with the first barrier isolation layer 90 without direct contact with the first polarity doped layer 30, so that selective burn-through of the burn-through paste may be achieved, a metalized contact area between the first metal electrode 70 and the first polarity doped layer 30 may be reduced, and the recombination of a metalized region may be reduced, thereby improving the conversion efficiency of the Topcon solar cell 100.

At the same time, the first barrier isolation layer 90 is obtained by partially removing the wrap plating layer formed on the first polarity doped layer 30 in the process of forming the second polarity doped layer 50, so that the first barrier isolation layer 90 may be obtained only by partially removing the wrap plating layer formed on the first polarity doped layer 30 without using additional deposition methods, thereby saving the process.

It is not difficult to understand that, after the first polarity doped layer 30 is formed, in the process of manufacturing the second polarity doped layer 50, the wrap plating layer may be formed on the first polarity doped layer 30. In the traditional technical solution, the wrap plating layer formed on the first polarity doped layer 30 needs to be completely removed, while in the present disclosure, only the wrap plating layer is partially removed, and part of the wrap plating layer is retained to form the first barrier doped layer 90, so that the first barrier isolation layer 90 may be formed without using additional processes, thereby saving the process steps.

In the present disclosure, the first surface 11 and the second surface 12 may be the front and back sides of the silicon substrate 10 respectively, the silicon substrate 10 may be a P-type silicon substrate or an N-type silicon substrate, the first polarity doped layer 30 may be a P-type doped layer or an N-type doped layer, and one of the first metal electrode 70 and the second metal electrode 80 is a P-type electrode, and the other is an N-type electrode.

The first polarity doped layer 30 may be formed by deposition on the first surface 11 of a silicon wafer. Of course, in some embodiments, the first polarity doped layer 30 may also be formed by diffusion on the silicon substrate 10. In this case, the substrate portion below the first polarity doped layer 30 formed by diffusion may be regarded as the silicon substrate 10.

It is to be noted that, in the present disclosure, the burn-through paste refers to a metal paste with a relatively strong burn-through capability, which may be a silver paste or a silver-aluminum paste, etc., and can completely burn through the first passivation layer 40, so that the first metal electrode 70 may be in contact with a film layer below the first passivation layer 40. For example, in a possible embodiment, the content of glass powder of the burn-through paste may be higher than that of the traditional paste, so that the burn-through paste has stronger burn-through capability.

### Embodiment 2

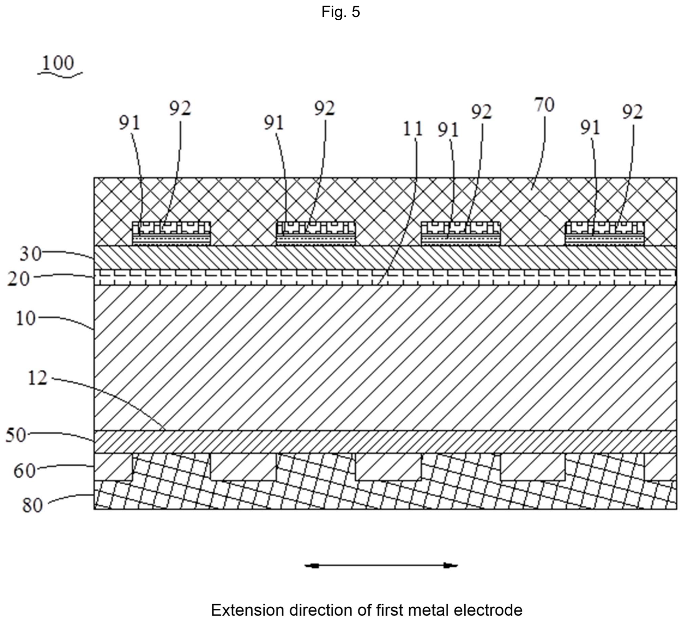

Referring to Fig. 5, in some embodiments, the first barrier isolation layer 90 may include an insulating isolation layer 91 stacked on the first polarity doped layer 30 and a barrier doped layer 92 stacked on the insulating isolation layer 91, and at the position corresponding to the first barrier isolation layer 90, the first metal electrode 70 burns through the first passivation layer 40 to be in contact with the barrier doped layer 92, and a polarity of the barrier doped layer 92 is the same as that of the second polarity doped layer 50.

In this way, the first barrier isolation layer 90 on the first polarity doped layer 30 includes the insulating isolation layer 91 and the barrier doped layer 92. The existence of the insulating isolation layer 91 may prevent the barrier doped layer 92 from being in direct contact with the first polarity doped layer 30 to cause electric leakage.

In such an embodiment, the insulating isolation layer 91 may include at least one or a combination of a borosilicate glass layer, a phosphosilicate glass layer, and a borophosphosilicate glass layer.

Specifically, in the present disclosure, the second polarity doped layer 50 may be formed by diffusion or deposition on the second surface 12. The specific situations of two methods of forming the second polarity doped layer 50 are described in detail below.

The first case is that the second polarity doped layer 50 is formed by deposition. In this case, after the first polarity doped layer 30 is formed on the first surface 11, the wrap plating layer having the doped layer may be formed on the first polarity doped layer 30 in the process of depositing the second polarity doped layer 50.

When the first polarity doped layer 30 is the P-type doped layer and the second polarity doped layer 50 is the N-type doped layer, the wrap plating layer includes the phosphosilicate glass layer and the N-type doped layer stacked on the phosphosilicate glass layer. In this way, the first barrier isolation layer 90 may be obtained only by partially removing the wrap plating layer, the phosphosilicate glass layer is the insulating isolation layer 91, and the N-type doped layer is the barrier doped layer 9292.

When the first polarity doped layer 30 is the N-type doped layer and the second polarity doped layer 50 is the P-type doped layer, the wrap plating layer includes the borosilicate glass layer and the P-type doped layer stacked on the borosilicate glass layer. In this way, the first barrier isolation layer 90 may be obtained only by partially removing the wrap plating layer, the borosilicate glass layer is the insulating isolation layer 91, and the P-type doped layer is the barrier doped layer 9292.

Of course, it is understandable that, in the process of forming the first polarity doped layer 30, the phosphosilicate glass layer or the borosilicate glass layer may be formed on the first polarity doped layer 30. If the phosphosilicate glass layer or the borosilicate glass layer is not removed before forming the second polarity doped layer 50, then the borophosphosilicate glass layer may be formed in the process of forming the second polarity doped layer 50. In this case, the insulating isolation layer 91 is the borophosphosilicate layer.

The second case is that the second polarity doped layer 50 is formed by diffusion on the second surface 12. In this case, when the first polarity doped layer 30 is the P-type doped layer and the second polarity doped layer 50 is the N-type doped layer, the second polarity doped layer 50 may be formed by phosphorus diffusion on the second surface 12.

When the second polarity doped layer 50 is formed by diffusion, the phosphosilicate glass layer may be formed on the first polarity doped layer 30. In this case, the first barrier isolation layer 90 may be formed on a first shielding region 212 only by removing the phosphorosilicate glass layer in a local region of the first polarity doped layer 30, that is, the first barrier isolation layer 90 is the phosphorosilicate glass layer. Of course, it is understandable that, in the process of forming the first polarity doped layer 30, the borosilicate glass layer may be formed on the first polarity doped layer 30. If the borosilicate glass layer is not removed before forming the second polarity doped layer 50, then the borophosphosilicate glass layer may be formed in the process of forming the second polarity doped layer 50. In this case, the first barrier isolation layer 90 is the borophosphosilicate glass layer.

Similarly, when the first polarity doped layer 30 is the N-type doped layer and the second polarity doped layer 50 is the P-type doped layer, the second polarity doped layer 50 may be formed by boron diffusion on the second surface 12. In the process of forming the second polarity doped layer 50 by diffusion, the borosilicate glass layer may be formed on the first polarity doped layer 30. In this case, the first barrier isolation layer 90 may be formed on the first shielding region 212 only by removing the borosilicate glass layer in the local region of the first polarity doped layer 30, that is, the first barrier isolation layer 90 is the borosilicate glass layer. Of course, it is understandable that, in the process of forming the first polarity doped layer 30, the phosphosilicate glass layer may be formed on the first polarity doped layer 30. If the phosphosilicate glass layer is not removed before forming the second polarity doped layer 50, then the borophosphosilicate glass layer may be formed in the process of forming the second polarity doped layer 50. In this case, the first barrier isolation layer 90 is the borophosphosilicate glass layer.

### Embodiment 3

Referring to Fig. 1, in some embodiments, in a first predetermined direction, a ratio of a length of the first metal electrode 70 in contact with the first polarity doped layer 30 to a total length of the first metal electrode 70 is 30%-80%.

In this way, by setting the length of the first metal electrode 70 in contact with the first polarity doped layer 30 within the above ratio range, the metalized contact area may be effectively reduced to reduce recombination while avoiding excessive resistance caused by the too small contact area. That is, the relationship between recombination and resistance may be balanced to improve the efficiency of the Topcon solar cell 100.

Specifically, in such an embodiment, the ratio of the length of the first metal electrode 70 in contact with the first polarity doped layer 30 to the total length of the first metal electrode 70 may be, for example, 30%, 40%, 50%, 60%, 70%, 80% or any value between 30% and 80%.

Further, in such an embodiment, after careful research and derivative discoveries by the inventors of the present disclosure, in order to maximize the balance between metalized recombination and resistance while improving the conversion efficiency of the Topcon solar cell 100 as much as possible, the ratio of the length of the first metal electrode 70 in contact with the first polarity doped layer 30 to the total length of the first metal electrode 70 may preferably be within the range of 40%-60%, for example, 40%, 45%, 50%, 55%, 60% and any value between 40% and 60%.

### Embodiment 4

In some embodiments, the first polarity doped layer 30 may be the P-type doped layer, and the barrier doped layer 92 and the second polarity doped layer 50 are both the N-type doped layers.

In this way, when the barrier doped layer 92 on the P-type doped layer is the N-type doped layer, by arranging the N-type doped layer on the P-type doped layer, a bonding tension between the first passivation layer 40 and the N-type doped layer is greater than a bonding tension between the passivation layer and the P-type doped layer, so that a soldering tension of a solder joint during soldering may be effectively improved when the solder joint is subsequently arranged, thereby effectively avoiding the detachment of the solder joint during soldering and improving the reliability of soldering.

### Embodiment 5

In some embodiments, a bonding tension between the first metal electrode 70 and the barrier doped layer 92 is greater than a bonding tension between the first metal electrode 70 and the first polarity doped layer 30.

In this way, by arranging the barrier doped layer 92, the stability of the first metal electrode 70 may be increased, and the first metal electrode 70 may be effectively prevented from shifting or falling off.

### Embodiment 6

In some embodiments, a bonding tension between the barrier doped layer 92 and the first passivation layer 40 is greater than a bonding tension between the first polarity doped layer 30 and the first passivation layer 40.

In this way, the bonding tension between the barrier doped layer 92 and the first passivation layer 40 is relatively large, so that the tension of the solder joint arranged on the first passivation layer 40 may be effectively increased, and the solder joint is prevented from falling off during soldering.

Specifically, in such an embodiment, the first polarity doped layer 30 is the P-type doped layer, the barrier doped layer 92 is the N-type barrier layer, and the bonding tension between the N-type doped layer and the first passivation layer 40 is greater than the tension between the P-type doped layer and the first passivation layer 40.

Further, in such an embodiment, in some embodiments, the Topcon solar cell 100 further includes a solder joint (not shown in the figure) connected to the first metal electrode 70. The solder joint is arranged on the first passivation layer 40 and at least partially located above the barrier doped layer 92.

In this way, the solder joint is at least partially arranged above the barrier doped layer 92, so that the soldering tension of the solder joint during soldering may be increased.

Further, in some embodiments, the solder joint at least partially burns through the first passivation layer 40 to be in contact with the barrier doped layer 92, and the bonding tension between the solder joint and the barrier doped layer 92 is greater than the bonding tension between the solder joint and the first polarity doped layer 30.

In this way, the bonding tension between the solder joint and the barrier doped layer 92 is relatively large, and the soldering tension of the solder joint during soldering may also be effectively increased.

Specifically, in such an embodiment, the solder joint may be a P-type solder joint, and the paste for forming the solder joint may be the same as or different from the paste for forming the first metal electrode 70, which is not specifically limited herein.

### Embodiment 7

In some embodiments, a projected area of the barrier doped layer 92 on the silicon substrate 10 is greater than or equal to a projected area of the solder joint on the silicon substrate 10, and the solder joint is completely located in a projection region of the barrier doped layer 92.

In this way, the solder joint is completely located in the region where the first barrier doped layer 92 is located, and the entire lower portion of the solder joint has the barrier doped layer 92, which may maximize the soldering tension at the solder joint, thereby ensuring the reliability of soldering.

Specifically, in such an embodiment, the area of the barrier doped layer 92 may preferably be just equal to the projected area of the solder joint or slightly greater than the projected area of the solder joint, which is not specifically limited herein.

### Embodiment 8

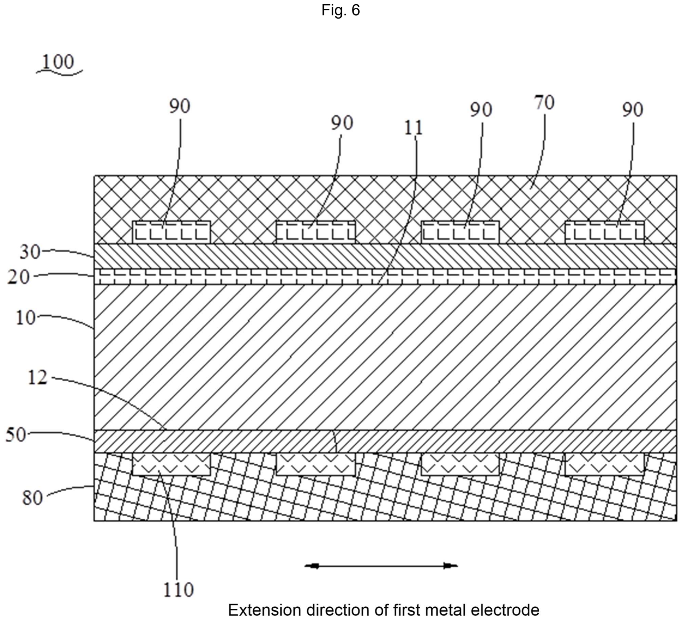

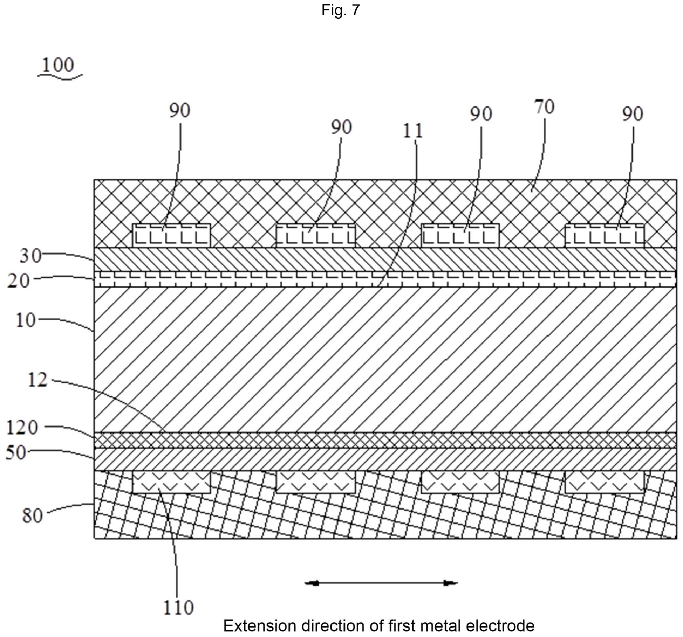

Referring to Fig. 6 and Fig. 7, in some embodiments, in an extension direction of the second metal electrode 80, at a position corresponding to the second metal electrode 80, a plurality of second barrier isolation layers 110 arranged at intervals in the extension direction of the second metal electrode 80 are arranged between the second polarity doped layer 50 and the second passivation layer 60, and the second metal electrode 80 is also made of the burn-through paste. At a position corresponding to the second barrier isolation layer 110, the second metal electrode 80 burns through the second passivation layer 60 to be in contact with the second barrier isolation layer 110, and between two adjacent second barrier isolation layers 110, the second metal electrode 80 burns through the second passivation layer 60 to be in contact with the second polarity doped layer 50, and the second barrier isolation layer 110 includes the phosphosilicate glass layer or the borosilicate glass layer. In this embodiment, the extension direction of the first metal electrode 70 may be the same as the extension direction of the second metal electrode 80.

In this way, by arranging the second barrier isolation layer 110, in the process of manufacturing the second metal electrode 80, the second metal electrode 80 partially burns through the second passivation layer 90 to be in contact with the second polarity doped layer 50, and only burns through the second passivation layer 90 at the second barrier isolation layer 110 to be in contact with the second barrier isolation layer 110 without direct contact with the first polarity doped layer 50, so that selective burn-through of the burn-through paste may be achieved, a metalized contact area between the second metal electrode 80 and the second polarity doped layer 50 may be reduced, and the recombination of a metalized region may be reduced, thereby improving the conversion efficiency of the Topcon solar cell 100.

Specifically, in such an embodiment, the second polarity doped layer 50 may be formed by deposition or diffusion. When the second polarity doped layer 50 is the N-type doped layer, in the process of forming the second polarity doped layer 50, the phosphosilicate glass layer may be formed on the second polarity doped layer 50. In the subsequent removal process, the phosphosilicate glass layer at a second shielding region 812 of the second polarity doped layer 50 is retained to form the second barrier isolation layer 110, that is, the second barrier isolation layer 110 is the phosphosilicate glass layer.

When the second polarity doped layer 50 is the P-type doped layer, in the process of forming the second polarity doped layer 50, the borosilicate glass layer may be formed on the second polarity doped layer 50. In the subsequent removal process, the borosilicate glass layer at the second shielding region 812 of the second polarity doped layer 50 is retained to form the second barrier isolation layer 110, that is, the second barrier isolation layer 110 is the borosilicate glass layer.

### Embodiment 9

Referring to Fig. 7, in some embodiments, a second tunneling oxide layer 120 may be arranged between the second polarity doped layer 50 and the second surface 12. In this way, by arranging the second tunneling oxide layer 120, a tunneling passivation function may be achieved for the second surface 12 and the passivation effect of the second surface 12 is enhanced.

Specifically, in such an embodiment, when the Topcon solar cell 100 has only the first tunneling layer 60, the Topcon solar cell 100 is a single-sided Topcon solar cell, and when the Topcon solar cell 100 has both the first tunneling layer 60 and the second tunneling oxide layer 120, the Topcon solar cell 100 may also be a double-sided Topcon solar cell, which is not specifically limited here. The first tunneling layer 60 and the second tunneling oxide layer 120 may both be tunneling silicon oxide layers.

### Embodiment 10

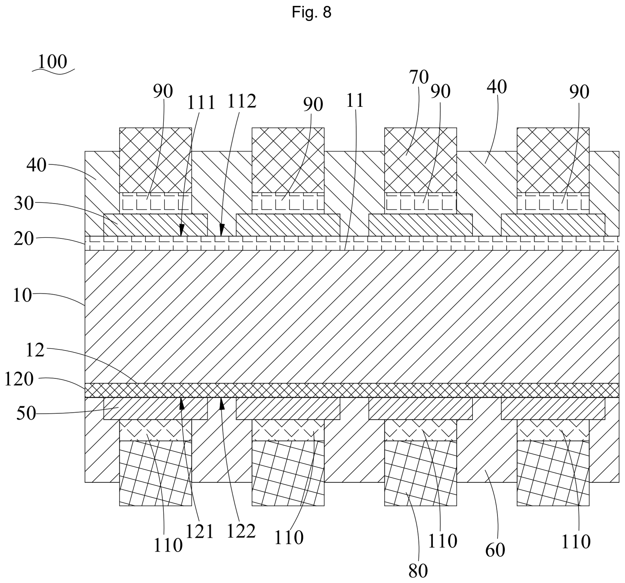

Referring to Fig. 8, in some embodiments, the first surface 11 has at least one first region 111 and at least one second region 112 which are sequentially and alternately arranged, the first polarity doped layer 30 is arranged on the first region 111 and does not cover the second region 112, and at least one first barrier isolation layer 90 is arranged above the first polarity doped layer 30 on the at least one first region 111.

In this way, the first polarity doped layer 30 only covers the first region 111 of the first surface 11 and does not cover the second region 112. The first surface 11 of the silicon substrate 10 is not completely covered with the first polarity doped layer 30, which may effectively reduce the parasitic absorption of light by the first polarity doped layer 30 and improve the conversion efficiency.

Further, in some embodiments, the silicon substrate 10 may preferably be the P-type silicon substrate 10, the first surface 11 is a light-facing surface, the second surface 12 is a backlight surface, the first polarity doped layer 30 is the P-type doped layer, and the second polarity doped layer 50 is the N-type doped layer.

In this way, on the one hand, the P-type silicon substrate 10 is used, and the manufacturing technology of the P-type silicon substrate 10 is more mature than that of the N-type substrate. On the other hand, the P-type doped layer covering only the first region 111 is used on the light-facing surface of the P-type silicon substrate 10. Since the passivation effect of the P-type doped layer on the P-type silicon substrate 10 is poor, the P-type doped layer is only arranged on the first region 111 for local passivation, and the second region 112 is directly passivated by the first passivation layer 40, which has better passivation performance and may improve the passivation effect of the first surface 11, thereby improving the electrical performance of the solar cell and further improving the efficiency.

In some embodiments, a thickness of the second polarity doped layer 50 is less than that of the first polarity doped layer 30.

In this way, when the silicon substrate 10 is the P-type silicon substrate 10 and the first polarity doped layer 30 is the P-type doped layer, the thickness of the first polarity doped layer 30 is set to be relatively large, so that the passivation effect of the first surface 11 may be improved, thereby improving the electrical performance of the solar cell.

In some embodiments, each of the first polarity doped layer 30 and the second polarity doped layer 50 may include a doped semi-insulating polysilicon layer. In this way, both the first polarity doped layer 30 and the second polarity doped layer 50 are made of semi-insulating polysilicon, which has less parasitic absorption than traditional polysilicon, that is, the use of such a material may reduce the parasitic absorption and improve the conversion efficiency.

### Embodiment 11

In some embodiments, an area ratio of the first region 111 to the first surface 11 (i.e., the area ratio of the first region 111) is less than 8%.

In this way, by setting the area ratio of the first region 111 to the first surface 11 within a range of less than 8%, the area ratio of the first polarity doped layer 30 may be greatly reduced, thereby reducing the parasitic absorption of the first polarity doped layer 30 and improving the efficiency.

At the same time, when the silicon substrate 10 is the P-type silicon substrate 10, the first polarity doped layer 30 is the P-type doped layer, and the first surface 11 is the light-facing surface, the area of the first region 111 is set to be relatively small, which may increase the area of the second region 112, thereby improving the passivation effect of the first surface 11, that is, the passivation effect of the first surface 11 may be improved while reducing the parasitic absorption, thereby improving the efficiency.

Further, in such an embodiment, the area ratio of the first region 111 to the first surface 11 is preferably less than 6%, and most preferably less than 5%.

### Embodiment 12

Referring to Fig. 8, in some embodiments, the second surface 12 may have at least one third region 121 and at least one fourth region 122 which are sequentially and alternately arranged, and the second polarity doped layer 50 is arranged on the third region 121 and does not cover the fourth region 122.

In this way, the second polarity doped layer 50 only covers the third region 121 of the second surface 12 and does not cover the fourth region 122. In this way, the second surface 12 of the silicon substrate 10 is not completely covered with the second polarity doped layer 50, which may effectively reduce the parasitic absorption of light by the second polarity doped layer 50 and improve the conversion efficiency.

In some embodiments, the area ratio of the third region 121 to the second surface 12 is greater than or equal to 30% and less than 100%.

In this way, when the silicon substrate 10 is the P-type silicon substrate 10, the second polarity doped layer 50 is the N-type doped layer, and the second surface 12 is the backlight surface, the area of the third region 121 of the second surface 12 is set to be relatively large, which may ensure the area ratio of the N-type doped layer while reducing the parasitic absorption, balance the passivation contact area and parasitic absorption, thereby improving the conversion efficiency.

Further, in such an embodiment, the area ratio of the third region 121 to the second surface 12 is preferably greater than or equal to 40% and less than 100%. Still further, in such an embodiment, the area ratio of the third region 121 to the second surface 12 is more preferably greater than or equal to 50% and less than 100%, and most preferably greater than or equal to 60% and less than 100%.

In the description of the present specification, descriptions of the reference terms "some embodiments", "a schematic embodiment", "an example", "a specific example", "some examples", or the like mean that specific features, structures, materials, or characteristics described in combination with the embodiment or the example are included in at least one embodiment or example of the present disclosure. In this specification, schematic representations of the above terms do not necessarily refer to the same embodiment or example. Furthermore, the specific features, structures, materials, or characteristics described may be combined in any suitable manner in any one or more embodiments or examples.

In addition, the above is only the preferred embodiments of the present disclosure and is not intended to limit the present disclosure. Any modifications, equivalent replacements and improvements and the like made within the spirit and principle of the present disclosure shall fall within the scope of protection of the present disclosure.

## Claims

1. A Topcon solar cell, comprising:
a silicon substrate having a first surface and a second surface opposite to each other;
a first tunneling oxide layer, a first polarity doped layer, and a first passivation layer sequentially stacked on the first surface;
a second polarity doped layer and a second passivation layer sequentially stacked on the second surface, wherein a polarity of the second polarity doped layer is opposite to that of the first polarity doped layer; and
a first metal electrode and a second metal electrode, wherein the first metal electrode is arranged on the first passivation layer, and the second metal electrode is arranged on the second passivation layer;
wherein in an extension direction of the first metal electrode, a plurality of first barrier isolation layers arranged at intervals are located below the first metal electrode, the first barrier isolation layer is located between the first passivation layer and the first polarity doped layer, and the first metal electrode is made of a burn-through paste;
at a position corresponding to the first barrier isolation layer, the first metal electrode burns through the first passivation layer to be in contact with the first barrier isolation layer, and
between two adjacent first barrier isolation layers, the first metal electrode burns through the first passivation layer to be in contact with the first polarity doped layer, and the second metal electrode at least partially penetrates through the second passivation layer to be in contact with the second polarity doped layer; and
the first barrier isolation layer is obtained by partially removing a wrap plating layer formed on the first polarity doped layer in the process of forming the second polarity doped layer.

2. The Topcon solar cell according to claim 1, wherein in the extension direction of the first metal electrode, a ratio of a length of the first metal electrode in contact with the first polarity doped layer to a total length of the first metal electrode is 30%-80%.

3. The Topcon solar cell according to claim 2, wherein in the extension direction of the first metal electrode, the ratio of the length of the first metal electrode in contact with the first polarity doped layer to the total length of the first metal electrode is 40%-60%.

4. The Topcon solar cell according to claim 1, wherein the first barrier isolation layer comprises an insulating isolation layer stacked on the first polarity doped layer and a barrier doped layer stacked on the insulating isolation layer, and at the position corresponding to the first barrier isolation layer, the first metal electrode burns through the first passivation layer to be in contact with the barrier doped layer, and a polarity of the barrier doped layer is the same as that of the second polarity doped layer.

5. The Topcon solar cell according to claim 4, wherein the first polarity doped layer is a P-type doped layer, and the second polarity doped layer and the barrier doped layer are both N-type doped layers.

6. The Topcon solar cell according to claim 5, wherein a bonding tension between the first metal electrode and the barrier doped layer is greater than a bonding tension between the first metal electrode and the first polarity doped layer; and/or
a bonding tension between the barrier doped layer and the first passivation layer is greater than
a bonding tension between the first polarity doped layer and the first passivation layer.

7. The Topcon solar cell according to claim 6, further comprising a solder joint connected to the first metal electrode, wherein the solder joint is arranged on the first passivation layer and at least partially located above the barrier doped layer.

8. The Topcon solar cell according to claim 7, wherein a projected area of the barrier doped layer on the silicon substrate is greater than or equal to a projected area of the solder joint on the silicon substrate, and the solder joint is completely located in a projection region of the barrier doped layer.

9. The Topcon solar cell according to claim 1, wherein the first surface has at least one first region and at least one second region which are sequentially and alternately arranged, the first polarity doped layer is arranged on the first region and does not cover the second region, and the at least one first barrier isolation layer is arranged above the first polarity doped layer on the at least one first region.

10. The Topcon solar cell according to claim 9, wherein an area ratio of the first region to the first surface is less than 8%.

11. The Topcon solar cell according to claim 1, wherein in an extension direction of the second metal electrode, at a position corresponding to the second metal electrode, a plurality of second barrier isolation layers arranged at intervals in the extension direction of the second metal electrode are arranged between the second polarity doped layer and the second passivation layer, and the second metal electrode is also made of the burn-through paste;
at a position corresponding to the second barrier isolation layer, the second metal electrode burns through the second passivation layer to be in contact with the second barrier isolation layer, and between two adjacent second barrier isolation layers, the second metal electrode burns through the second passivation layer to be in contact with the second polarity doped layer, and the second barrier isolation layer comprises a phosphosilicate glass layer or a borosilicate glass layer.

12. The Topcon solar cell according to claim 11, wherein a second tunneling oxide layer is arranged between the second polarity doped layer and the second surface.

13. The Topcon solar cell according to claim 11, wherein the second surface has at least one third region and at least one fourth region which are sequentially and alternately arranged, and the second polarity doped layer is arranged on the third region and does not cover the fourth region.

14. The Topcon solar cell according to claim 13, wherein an area ratio of the third region to the second surface is greater than or equal to 30% and less than 100%.

15. A cell assembly, comprising at least one Topcon solar cell according to any one of claims 1 to 14.

16. A photovoltaic system, comprising the cell assembly according to claim 15.
